# FASCICULE DE BREVET EUROPEEN

(11) **EP 1 049 820 B1**
(45) Date de publication et mention de la délivrance du brevet: **20.08.2003**
(21) Numéro de dépôt: 99956144.2
(22) Date de dépôt: 25.11.1999
(51) Int. Cl.: C30B 11/00, C30B 11/12, C30B 19/02, C30B 29/36, C30B 25/02

(54) **PRODEDE DE CROISSANCE CRISTALLINE SUR SUBSTRAT**
VERFAHREN ZUR KRISTALLZÜCHTUNG AUF EINEM SUBSTRAT
METHOD FOR EPITAXIAL GROWTH ON A SUBSTRATE

(30) Priorité: 25.11.1998 FR 9814831; 07.05.1999 FR 9905840
(43) Date de publication de la demande: 08.11.2000
(73) Titulaire: Centre National de la Recherche Scientifique (CNRS), 75794 Paris Cédex 16 (FR)
(72) Inventeur: LEYCURAS, André, F-06560 Valbonne (FR)
(74) Mandataire: Texier, Christian
(86) Numéro de dépôt international: FR9902910
(87) Numéro de publication internationale: WO00031322

(56) Documents cités:
- GB-A- 1 139 802
- US-A- 4 582 561
- US-A- 4 614 672
- POTEMSKI: "Gradient reversal termination of liquid phase epitaxial growth" IBM TECHNICAL DISCLOSURE BULLETIN,US,IBM CORP. NEW YORK, vol. 15, no. 11, avril 1973 (1973-04), pages 3440-3441-3441, XP002118352 ISSN: 0018-8689
- MUENCH W V ET AL: "SILICON CARBIDE BLUE-EMITTING DIODES PRODUCED BY LIQUID-PHASE EPITAXY" SOLID STATE ELECTRONICS, vol. 21, no. 9, 1 septembre 1978 (1978-09-01), pages 1129-1132, XP002001455 ISSN: 0038-1101

## Description

L'invention concerne le domaine des procédés de dépôt de couches minces et de croissance cristalline de matériaux sur un substrat. L'invention concerne aussi un réacteur pour la mise en oeuvre de ce procédé.

Par exemple, il peut s'agir d'un procédé de croissance de composés binaires. Certains composés binaires n'existent pas à l'état liquide et on ne dispose pas non plus de grands cristaux de ces composés permettant une croissance par homoépitaxie. C'est le cas notamment du carbure de silicium (SiC) et du nitrure d'aluminium (AIN).

Pour le SiC en particulier, des cristaux sont obtenus par la méthode Acheson, puis ils servent de germes pour les faire croître par la méthode Lely. Les cristaux ainsi obtenus sont de très bonne qualité cristalline mais typiquement leurs dimensions sont de l'ordre d'un centimètre. Ils sont trop petits pour une exploitation industrielle, il faut donc une méthode de croissance capable de les faire pousser jusqu'à 5 à 10 cm. La méthode dite de Lely modifiée est actuellement la seule méthode industrielle de production de SiC sous les polytypes 6H ou 4H. Elle consiste à sublimer une charge de SiC granulaire à 2300°C et à la condenser sur un germe placé au dessus à 2100°C. Elle n'est pas sans inconvénients surtout à cause de la température à laquelle la croissance doit être faite : 2300°C. L'équipement pour monter à ces températures est très onéreux et les difficultés rencontrées pour augmenter la taille des cristaux sont très grandes. Par ailleurs, les cristaux obtenus par cette méthode présentent des microcanaux nuisibles pour la réalisation de grands composants de puissance.

La croissance cristalline de cristaux de SiC par un dépôt chimique en phase vapeur (dite CVD, acronyme anglosaxon de Chemical Vapour Deposition) à haute température et la croissance en phase liquide donnent des vitesses de croissance élevées mais ne permettent pas de faire croître, latéralement, c'est à dire principalement dans le plan du dépôt, des cristaux dont les dimensions dans ce plan sont satisfaisantes.

Il existe aussi une méthode CVD « basse température » pour la croissance du SiC, qui permet de faire croître du SiC sur des substrats de silicium de très grandes dimensions, mais la qualité des couches en résultant est très insuffisante pour la fabrication de. composants électroniques à cause de la présence d'une grande densité de dislocations dues au désaccord de maille cristalline entre la couche et le substrat.

La situation pour l'AIN est encore moins favorable puisqu'il n'existe pas de fournisseur de cristaux de ce matériau.

Un but de la présente invention est de fournir un procédé et un réacteur permettant d'améliorer la qualité cristalline de cristaux obtenus par croissance à partir d'une phase liquide sur un substrat.

Ce but est atteint grâce au procédé selon la revendication 1.

En effet, la croissance par pointes permet de réduire la densité de dislocations généralement importante, du fait que le premier matériau présente lui-même beaucoup de dislocations, par exemple à cause d'un désaccord de maille entre le premier matériau et le substrat sur lequel le premier matériau est hétéroepitaxié, alors que vers l'extrémité des pointes, qui se trouve dans le liquide, à l'opposé de la surface du premier matériau, il y a relaxation des contraintes, ce qui entraîne une légère diminution du nombre de dislocations, mais même à densité de dislocations constante, du fait de la petite surface de chaque pointe, celle-ci ne présente que peu de dislocations.

Avantageusement, le procédé selon l'invention comprend une étape consistant à inverser le sens du gradient de température.

Ainsi, lorsque ces pointes ont atteint une dizaine de micromètres de haut, une inversion du gradient de température provoque une croissance latérale à partir du sommet de ces pointes. Les dislocations qui étaient très nombreuses à la surface du premier matériau sont peu nombreuses au sommet des pointes et très rares dans les cristaux qui ont poussé latéralement. Ces cristaux sont parfaitement orientés les uns par rapport aux autres et coalescent pour former un seul monocristal de très haute qualité cristalline quand l'épaisseur devient suffisamment grande. Le diamètre maximum du monocristal est lié au diamètre maximum du substrat de départ, par exemple 300 millimètres dans le cas de SiC/Si.

L'invention concerne aussi un réacteur de croissance cristalline pour la mise en oeuvre du procédé selon l'invention, caractérisé par le fait qu'il comprend des moyens de chauffage permettant de générer un gradient de température, perpendiculairement à la surface libre du matériau en fusion.

En effet, la présence d'un gradient de température permet d'obtenir une croissance par pointes s'étendant dans la direction du gradient, plutôt qu'une croissance bidimensionnelle parallèlement au plan du premier matériau.

D'autres intérêts, buts et avantages de l'invention apparaîtront à la lecture de la description détaillée qui suit.

L'invention sera aussi mieux comprise à l'aide des références aux dessins sur lesquels
- la figure 1 est une représentation schématique de différentes étapes d'un exemple de mise en oeuvre du procédé selon l'invention ;
- la figure 2 est une representation schématique des différentes étapes d'un autre exemple de mise en oeuvre d'un procédé selon l'invention ;
- la figure 3 est une représentation schématique en coupe médiane et longitudinale d'un exemple de réacteur conforme à la présente invention ;
- la figure 4 est une représentation en perspective éclatée de l'agencement des premiers moyens de chauffage et du conduit, entrant dans la composition du réacteur représenté sur la figure 3 ;
- la figure 5 est une vue en élévation de dessus d'une pièce permettant de maintenir le conduit à l'intérieur de l'enceinte d'un réacteur représenté sur la figure 3 ;
- la figure 6 est une représentation schématique en coupe médiane et longitudinale d'un autre exemple de réacteur conforme à la présente invention ; et
- la figure 7 est une représentation schématique en coupe médiane et longitudinale d'encore un autre exemple de réacteur conforme à la présente invention.

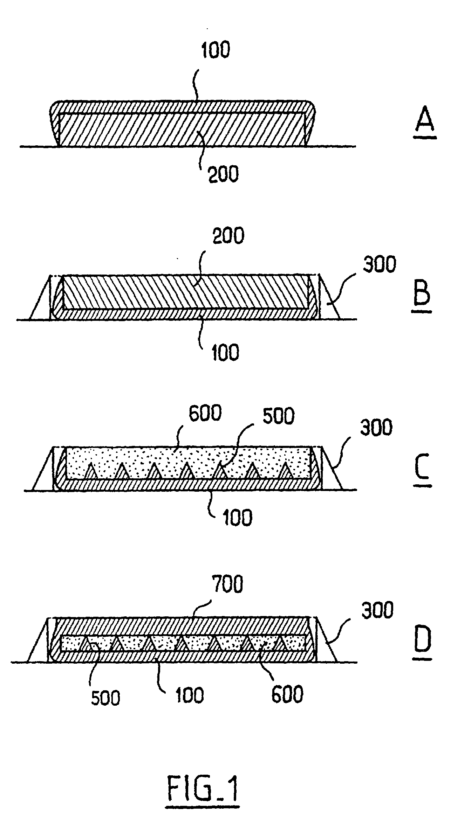

Selon un premier exemple de mise en oeuvre du procédé selon l'invention, représenté sur la figure 1, celui-ci comprend :
- une étape (a) de croissance d'un premier matériau 100 sur un substrat, constitué d'un deuxième matériau 200 (figure 1A) ;
- une étape (b) consistant à placer horizontalement le substrat, avec le premier matériau 100 en dessous du deuxième matériau 200, dans un creuset 300 (figure 1B) ;
- une étape (c) consistant à porter le deuxième matériau 200 à la fusion, sous flux de gaz neutre à pression élevée, en conservant le premier matériau 100 à l'état solide, le deuxième matériau correspondant alors dans l'état fondu, à la référence 600 ;
- une étape (d) consistant à établir un gradient de température perpendiculaire à la surface libre du matériau en fusion, tel que l'interface entre le premier matériau 100 et le deuxième matériau en fusion 600, soit à une température plus élevée que la température de la surface libre du deuxième matériau en fusion 600, et à rajouter au flux de gaz neutre balayant la surface du deuxième matériau en fusion 600, un gaz précurseur dont au moins une première espèce atomique participe, avec au moins une deuxième espèce atomique provenant du deuxième matériau en fusion 600, à la croissance d'un quatrième matériau 500, cette croissance s'effectuant par pointes de quatrième matériau 500, en continuité cristalline avec le premier matériau 100 (fig. 1C), à partir de l'interface du premier matériau 100 et du deuxième matériau en fusion 600 ;
- une étape (e) consistant à inverser le sens du gradient de température ; et
- une étape (f) consistant à faire croître latéralement, dans un plan principalement parallèle à la surface libre du deuxième matériau en fusion 600, des cristaux à partir des germes de croissance que constituent les pointes (figure 1D).

Au cours de l'étape (a), une couche mince monocristailine du premier matériau 100 est déposée sur un substrat d'un deuxième matériau 200 par une méthode classique de dépôt, connue de l'homme du métier, par exemple un dépôt chimique en phase vapeur.

Pour l'exemple ici décrit, le substrat constitué du deuxième matériau 200 est du silicium monocristallin et le premier matériau 100 est du carbure de silicium. La couche monocristalline de carbure de silicium obtenue a une forte densité de dislocations du fait du désaccord de paramètres cristallins entre le silicium et le carbure de silicium.

Au cours de l'étape (b), le substrat et la couche déposée dessus sont placés, couche sous substrat, horizontalement dans un réacteur spécial à gradient de température vertical contrôlé et sans gradient horizontal. La hauteur du creuset 300 est telle que lors de la fusion du substrat de silicium, le liquide ne dépasse pas le bord du creuset 300. Cette condition permet de limiter les fuites de liquide en cas de rupture des bords verticaux de la couche du premier matériau 100 qui est à la fois creuset et germe de croissance.

Après les opérations habituelles de mise en route du réacteur, un gaz vecteur neutre (par exemple de l'argon) est introduit dans le réacteur, de préférence à une pression égale à la pression atmosphérique ou plus, pour limiter l'évaporation physique ou réactive du liquide constitué du deuxième matériau en fusion 600, sous un débit suffisant pour assurer une concentration quasi uniforme de gaz précurseur sur tout le substrat.

Au cours de l'étape (c), la température est élevée au dessus du point de fusion du deuxième matériau 200, ici le silicium, en assurant une température sur la surface libre du deuxième matériau en fusion 600 inférieure à celle de l'interface entre le premier matériau 100 et le deuxième matériau en fusion 600.

L'épaisseur du deuxième matériau en fusion 600 au dessus du premier matériau 100 est avantageusement de l'ordre de la centaine ou de quelques centaines de micromètres, ou même de plusieurs millimètres.

Au cours de l'étape (d), un gaz précurseur (par exemple le propane pour SiC) est mélangé au gaz vecteur. Le gaz précurseur se décompose à la surface du deuxième matériau en fusion 600 et la première espèce atomique qu'il apporte, ici le carbone, diffuse vers l'interface entre les pointes cristallines et le deuxième matériau en fusion 600 (Si) pour participer à la croissance du quatrième matériau 500, ici le même que le premier matériau 100, c'est-à-dire le carbure de silicium. Les autres composants du gaz précurseur sont évacués par le gaz vecteur vers la sortie du réacteur.

Au cours de l'étape (d), il y a croissance des pointes cristallines du quatrième matériau 500 sur la couche du premier matériau 100, dans le deuxième matériau en fusion 600. La limite supérieure de la pression partielle du gaz précurseur qui ne doit pas être atteinte est celle qui provoquerait la formation d'une couche continue du quatrième matériau 500 en surface du deuxième matériau en fusion 600, ce qui aurait pour effet de bloquer instantanément toute croissance. Cette pression partielle limite dépend de la température du deuxième matériau en fusion 600, elle est typiquement de 1000 Pascal.

Les pointes cristallines, dans les conditions définies ci-dessus, sont assez régulièrement espacées et réparties.

L'étape (e) est démarrée lorsque les pointes cristallines ont atteint une hauteur de 10 micromètres environ. Elle consiste à inverser le sens du gradient de température, c'est à dire que la surface libre du deuxième matériau en fusion 600 est portée à une température supérieure à celle de l'interface entre le deuxième matériau en fusion 600 et le premier matériau 100, tous les autres paramètres restant identiques. Ceci provoque une croissance latérale du quatrième matériau 500, ici le SiC, à partir du sommet des pointes cristallines, que l'on poursuit au cours de l'étape (f).

L'étape (f) est poursuivie jusqu'à ce que les cristaux coalescent en une couche épaisse monocristalline.

On obtient finalement une couche complète 700 de quatrième matériau (SiC) par coalescence de tous les microcristaux qui ont poussé latéralement à partir des sommets des pointes cristallines.

Pour obtenir une couche plus épaisse, après épuisement du deuxième matériau en fusion 600, il est possible de refroidir le réacteur et de procéder à une étape (g) consistant à remettre une charge du deuxième matériau 200 sur le quatrième matériau 500 pour en poursuivre la croissance en épaisseur. Ainsi, pour l'exemple ici décrit, une charge de silicium est déposée sur la couche 700. On reprend alors la croissance en portant le deuxième matériau en fusion 600 et en balayant sa surface comme à l'étape (f), c'est à dire sans passer par une nouvelle étape de formation de pointes cristallines.

La vitesse de croissance du quatrième matériau 500, typique ainsi obtenue est de plusieurs dizaines de micromètres par heure.

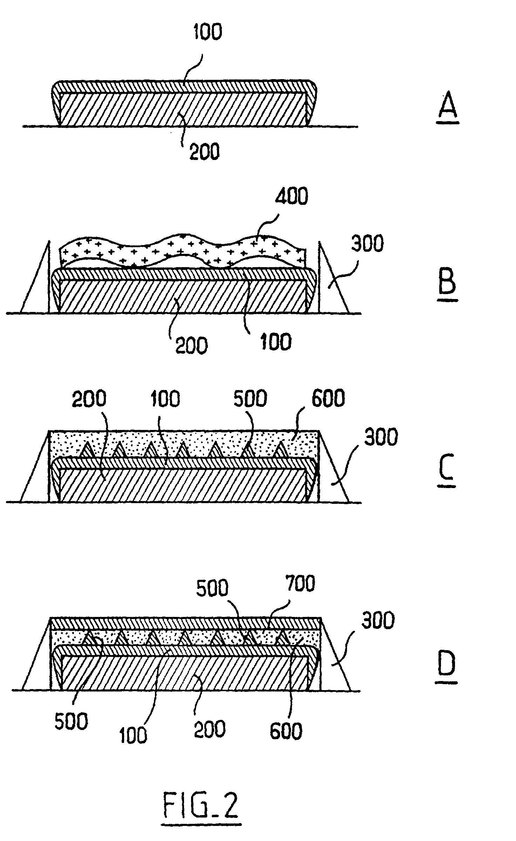

Selon un deuxième exemple de mise en oeuvre du procédé selon l'invention, représenté sur la figure 200, celui-ci comprend :
- une étape (a') équivalente à l'étape (a) déjà décrite (figure 2A) ;
- une étape (b') consistant à placer horizontalement le substrat dans un creuset 300, avec le premier matériau 100 au-dessus du deuxième matériau 200 et un troisième matériau 400 sur le premier (figure 2B) ;
- une étape (c') consistant à porter le troisième matériau 400 en fusion en conservant le premier matériau 100 et de deuxième matériau 200, à l'état solide ; et
- des étapes (d'), (e'), (f'), et éventuellement (g') respectivement équivalente aux étapes (d), (e), (f), et (g) déjà décrites.

Dans le cas de la croissance du nitrure d'aluminium AIN par le procédé selon l'invention, les premier 100 et quatrième 500 matériaux sont du nitrure d'aluminium, le deuxième matériau 200 est du saphir ou encore du carbure de silicium, le troisième matériau 400 est de l'aluminium (Al).

Ainsi, du nitrure d'aluminium est déposé sur du saphir, au cours de l'étape (a'). Le substrat de saphir est placé dans le creuset 300 avec le nitrure d'aluminium sur le dessus, au cours de l'étape (b'). De l'aluminium est porté à l'état liquide sur le nitrure d'aluminium au cours de l'étape (c').

L'ammoniaque ou l'azote sont utilisés comme gaz précurseurs en mélange avec un gaz vecteur, pour fournir l'azote, comme première espèce atomique, au cours de l'étape (d'). Le reste du procédé est équivalent à celui déjà décrit.

La présente invention permet de réaliser des tranches de SiC sans microcanaux, par exemple sous les polytypes 3C et 6H, de grands diamètres (jusqu'à 200 mm et plus), à une température de 1500°C au lieu de 2300°C, dans un réacteur bon marché en investissement et en coût de fonctionnement.

Le procédé selon l'invention ici illustré avec SiC et AIN peut être mis en oeuvre pour la croissance d'autres composés binaires, ainsi que des composés ternaires, etc.

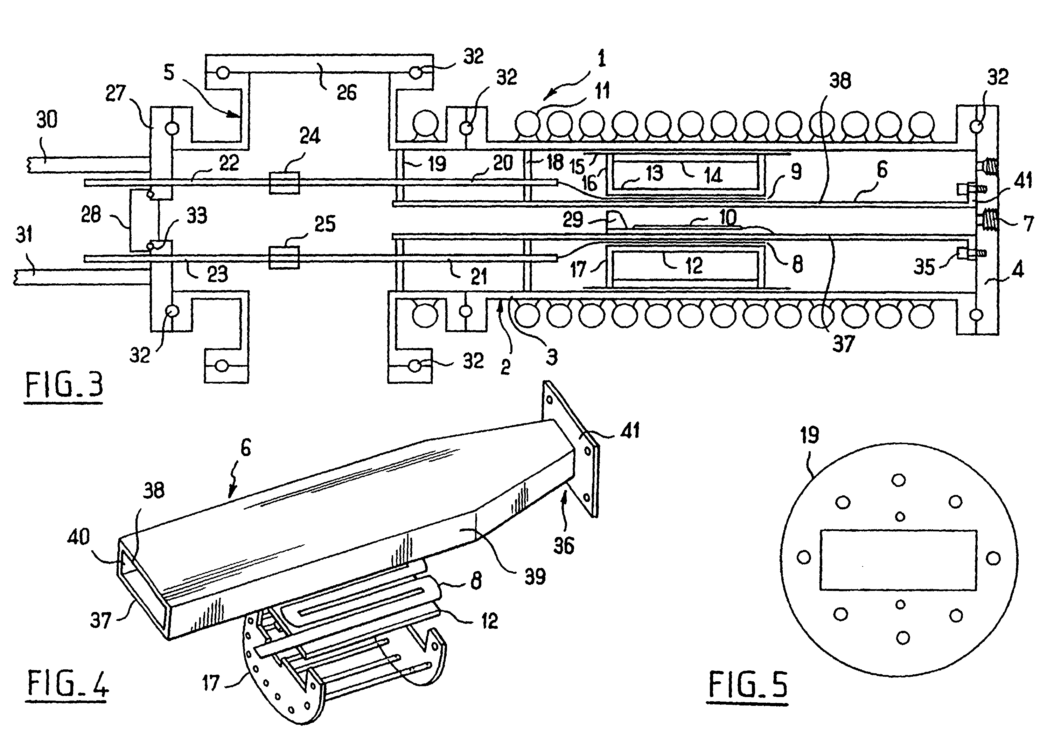

Un exemple non limitatif de réacteur selon l'invention est représenté à la figure 3. Ce réacteur 1 comprend une enceinte 2 constituée d'un tube 3, d'un premier obturateur 4 situé à l'une des extrémités de ce tube 3, et d'une croix de sortie 5 située à l'extrémité opposée du tube 3, par rapport au premier obturateur 4. L'ensemble du réacteur 1 est étanche et peut éventuellement résister à une pression de quelques MPa. L'étanchéité du réacteur 1 est assurée par des joints 32, 33.

La croix de sortie 5 peut être remplacée par un élément en forme de "T".

L'axe du tube 3 est à l'horizontal. A l'intérieur du tube 3 est disposé un conduit 6 coaxial à celui-ci A l'extérieur du tube 3 sont disposés des moyens de refroidissement 11 aptes à refroidir le tube 3. Le tube 3 est avantageusement un cylindre en acier inoxydable.

La croix 5 est de préférence fixe car l'une de ses sorties est reliée au système de pompage.

La croix de sortie 5 comporte un orifice inférieur et un orifice supérieur, radialement opposés dans la direction verticale. L'orifice inférieur de cette croix de sortie 5 débouche sur une pompe et un régulateur de pression pour les basses pressions, soit sur un détendeur pour une pression supérieure à la pression atmosphérique, ceci afin d'évacuer les gaz à pression constante. Ces appareils ne sont pas représentés sur la figure 3.. L'orifice supérieur de la croix de sortie 5 est obturé hermétiquement par un deuxième obturateur 26. La croix de sortie 5 possède en outre un orifice longitudinalement opposé au tube 3. Cet orifice peut être éventuellement muni d'un passage tournant. Dans le mode de réalisation ici présenté, cet orifice est obturé par un troisième obturateur 27 perpendiculaire à l'axe du tube 3. Le troisième obturateur 27 peut éventuellement être équipé d'une fenêtre ou d'un miroir mobile pour des mesures optiques à l'intérieur du conduit 6. Ce troisième obturateur 27 comporte une porte hermétique 28 permettant d'introduire ou d'extraire des substrats 10 du réacteur 1. Le troisième obturateur 27 comporte aussi des guides 30, 31. Ces guides 30, 31 sont perpendiculaires au plan de l'obturateur 27 et sont fixés solidairement à celui-ci. Ces guides 30, 31 servent à guider horizontalement un manipulateur non représenté sur les figures. Le troisième obturateur 27 comporte aussi des passages pour des premières amenées de courant 22, 23. Les parties des premières amenées de courant 22, 23, situées vers l'intérieur de l'enceinte 2, sont munies de connecteurs 24, 25.

Un conduit 6 est positionné et maintenu dans le tube 3 grâce à des moyens de fixation 35 du conduit 6 sur le premier obturateur 4. Ainsi, le conduit 6 est maintenu de manière à être libre de tout contact avec le tube 3. Ce qui permet de limiter les pertes par conduction thermique et d'éviter les contraintes thermiques.

Comme représenté sur la figure 4 le conduit 6 a une forme de tube à section transversale rectangulaire, présentant un rétrécissement 36 à une extrémité de celui-ci. Ce conduit 6 comporte deux plaques pour former les parois inférieure 37 et supérieure 38. Les parois inférieure 37 et supérieure 38 du conduit 6 sont horizontales et parallèles au plan du substrat 10 dans la position qu'il occupe pendant le dépôt. Des parois latérales 39, 40 joignent les bords longitudinaux des parois inférieure 37 et supérieure 38 pour fermer le conduit 6 longitudinalement. L'extrémité du conduit 6 située du côté du rétrécissement 36 a une section transverse carrée. Elle est munie d'une plaque support 41 perpendiculaire à l'axe longitudinal du conduit 6. Cette plaque support 41 présente une ouverture en vis-à-vis de l'embouchure du conduit 6 située du côté du rétrécissement 36. La plaque support 41 présente aussi des trous pour permettre la fixation du conduit 6 sur le premier obturateur 4, grâce aux moyens de fixation 35. Lorsque le conduit 6 est fixé sur le premier obturateur 4, l'embouchure du conduit 6 située du côté du rétrécissement 36 et l'ouverture dans la plaque support 41 se trouvent en vis-à-vis d'une entrée de gaz 7. Le conduit 6 est raccordé de manière étanche au premier obturateur 4, au niveau de l'entrée de gaz 7. La jonction étanche du conduit 6 sur le premier obturateur 4 est assurée par serrage d'un joint de graphite par exemple, grâce aux moyens de fixation 35.

L'entrée de gaz 7 sert à l'alimentation du réacteur 1 en gaz porteurs et précurseurs. Le premier obturateur 4 est aussi muni d'un passage de gaz 44, désaxé par rapport à l'axe de symétrie perpendiculaire au plan du disque que constitue le premier obturateur 4, et débouchant entre le conduit 6 et la paroi du tube 3. Le passage de gaz 44 permet aussi l'introduction de gaz dans le réacteur 1. Le passage de gaz 44 permet de faire circuler un gaz neutre vis-à-vis de l'ensemble des matériaux compris dans le réacteur 1 et vis-à-vis du matériau à déposer et des gaz circulant dans le conduit 6, ce gaz neutre empêchant le retour éventuel des gaz issus du procédé vers les parties chauffantes extérieures au conduit 6.

Préférentiellement, le conduit 6 est dans un matériau qui est à la fois bon conducteur thermique, bon isolant électrique, très réfractaire, très stable chimiquement et qui a une faible tension de vapeur aux températures d'utilisation, bien qu'éventuellement, un dépôt préalable du matériau destiné à être déposé sur un substrat 10 dans ce réacteur 1, est réalisé sur la face interne des parois 37, 38, 39, 40 du conduit 6, afin de minimiser la diffusion d'éventuels produits de dégazage pendant le fonctionnement normal du réacteur 1.

Avantageusement encore, ce matériau a une bonne tenue mécanique pour tolérer une faible épaisseur des parois 37, 38, 39, 40 du conduit 6. La faible épaisseur de ces parois 37, 38, 39, 40 permet de minimiser les pertes par conduction thermique et l'inertie thermique.

La tenue mécanique du matériau du conduit 6 est aussi importante pour pouvoir supporter ce conduit 6 uniquement par son extrémité située du côté du rétrécissement 36 et la plaque support 41.

Le matériau constitutif du conduit 6 est avantageusement du nitrure de bore pour une utilisation à des températures inférieures à 1200° C ou à plus hautes températures, si la présence d'une concentration élevée d'azote ne nuit pas à la qualité attendue du matériau élaboré.

Pour des températures plus élevées , le conduit 6 peut être réalisé en graphite. Dans un cas, comme dans l'autre, le conduit 6 peut être doublé intérieurement dans les parties les plus chaudes par un conduit secondaire en un matériau réfractaire, par exemple en métal réfractaire, inerte vis-à-vis des gaz circulant dans le conduit 6 et non polluant vis-à-vis du matériau déposé. Le conduit 6, qu'il soit en graphite ou en nitrure de bore, peut être réalisé soit par dépôt pyrolitique, soit par assemblage et/ou collage des différentes plaques constitutives des parois 37, 38, 39, 40 et de la plaque de support 41. Le conduit secondaire, quand il existe, double avantageusement intérieurement le conduit 6 de manière continue, c'est à dire que s'il est constitué de plaques, celles-ci sont jointives et qu'il n'y a pas de trous dans ces plaques. Le conduit secondaire est, par exemple, en tungstène, en tantale, en molybdène, en graphite ou en nitrure de bore.

A titre d'exemple, l'épaisseur des parois du conduit 6 est inférieure ou égale à environ 1 mm; la hauteur interne du conduit 6 est préférentiellement inférieure à 30 mm; la largeur du conduit 6 est égale à la largeur d'un substrat 10 ou à la somme des largeurs des substrats 10 traités au cours d'un même dépôt, plus environ 1 cm entre le ou les substrats 10 et les parois 39 et 40.

La partie du conduit 6 correspondant au rétrécissement 36, correspond à environ 1/5 de la longueur totale du conduit 6. La longueur de la partie à section constante du conduit 6 est égale à environ cinq fois le diamètre ou la longueur du plus grand substrat 10 que l'on veut utiliser ou cinq fois la somme des diamètres ou longueurs des substrats 10 sur lesquels un dépôt peut être effectué au cours de la même opération. Cette partie du conduit 6 s'étendant sur une longueur correspondant au diamètre ou à la longueur d'un substrat ou à la somme des longueurs ou des diamètres des substrats, est appelée ci-dessous zone de dépôt.

Avantageusement, le réacteur 1 est muni de premiers 8 et deuxièmes 9 moyens de chauffage, disposés au niveau de la zone de dépôt et situés de part et d'autre du plan du substrat 10.

Avantageusement, ces premiers 8 et deuxièmes 9 moyens de chauffage sont constitués d'éléments résistifs nus, c'est-à-dire que le matériau constitutif des premiers 8 et deuxièmes 9 moyens de chauffage est en contact direct avec le gaz circulant entre le conduit 6 et le tube 3.

Chaque élément résistif correspondant respectivement aux premiers 8 ou aux deuxièmes 9 moyens de chauffage est constitué d'une bande, c'est-à-dire un élément de plaque rigide, ou d'un ruban disposé(e) à plat, parallèlement aux parois inférieure 37 et supérieure 38 du conduit 6 (fig. 4). Ce ruban ou cette bande a une géométrie adaptée pour que, dans la zone de dépôt, les écarts à la température moyenne, sur la surface du substrat 10 destinée au dépôt, soient minimisés. Préférentiellement encore, ces écarts sont inférieurs à 3°C. Préférentiellement, chaque élément résistif a une dimension dans la direction parallèle à la largeur du conduit 6 qui est approximativement égale à cette dernière. La dimension de chaque élément résistif dans la direction parallèle à la longueur du conduit 6 est environ égale à deux fois la longueur de la zone de dépôt. Ceci pour optimiser l'uniformité du champ de température dans la zone de dépôt. Préférentiellement, chaque bande ou ruban d'un élément résistif est constitué(e) de bandes parallèles les unes aux autres, dans la direction longitudinale du tube 3, jointes deux à deux alternativement à l'une ou l'autre de leurs extrémités, de manière à former une géométrie en zigzag. D'autres géométries sont envisageables, telles des géométries en spirale.

Chaque élément résistif peut avoir un profil longitudinal de résistance par exemple obtenu en jouant sur son épaisseur, adapté pour favoriser la formation d'un profil de température contrôlé dans la zone de dépôt.

Chaque élément résistif a un grand coefficient de remplissage dans la zone de dépôt afin que leur température reste aussi peu que possible supérieure à la température locale souhaitée.

L'espace entre les bandes des éléments résistifs est suffisant pour éviter un arc ou un court circuit, mais est suffisamment faible aussi pour conserver une homogénéité du champ de température acceptable et pour qu'il ne soit pas nécessaire que sa température soit beaucoup plus élevée que celle du conduit qui est elle-même celle à laquelle se fait le dépôt. Préférentiellement, les premiers 8 et deuxièmes 9 moyens de chauffage sont alimentés sous une tension inférieure ou égale à 240 volts et plus préférentiellement encore inférieure, ou égale à 100, 110 ou 120 volts.

Eventuellement, les moyens premiers 8 et deuxièmes 9 moyens de chauffage sont chacun constitués de plusieurs éléments résistifs du type de ceux décrits ci-dessus.

Avantageusement les éléments résistifs sont réalisés dans un matériau conducteur et réfractaire à très faible tension de vapeur aux températures d'utilisation. Ce matériau peut être par exemple du graphite . un métal tel que le tantale ou le tungstène, ou encore un alliage réfractaire, etc. Préférentiellement, il s'agit ce graphite de haute pureté.

Les premiers 8 et deuxièmes 9 moyens de chauffage sont alimentés en courant indépendamment l'un de l'autre, de manière à pouvoir être portés à des températures différentes. On peut aussi générer un gradient de température perpendiculairement au plan du substrat 10. Ce gradient peut être de valeur positive, négative ou nulle par un contrôle indépendant de la puissance électrique appliquée a un des premiers 8 ou deuxièmes 9 moyens de chauffage.

Les premiers 8 ou les deuxièmes 9 moyens de chauffage peuvent être appliqués au contact des parois inférieure 37 et supérieure 38, à l'extérieur du conduit 6, au niveau de la zone de dépôt. Mais selon une variante préférentielle ceux-ci sont positionnés chacun respectivement à une distance de 1 à 3 mm d'une des parois inférieure 37 ou supérieure 38, à l'extérieur du conduit 6. Les premiers 8 et les deuxièmes 9 moyens de chauffage sont maintenus plaqués contre les parois inférieure 37 et supérieure 38 par les plaques de maintien 12, 13 électriquement isolantes et thermiquement conductrices. Dans le cas où le conduit 6 n'est pas un matériau électriquement isolant, il faut mettre entre le conduit 6 et les premiers 8 et deuxièmes 9 moyens de chauffage, un matériau intermédiaire, électriquement isolant, pour éviter tout contact électrique, surtout dans la zone chaude, si de très hautes températures doivent être atteintes.

Ces plaques de maintien 12, 13 peuvent être en nitrure de bore et faire 1 mm d'épaisseur environ ou moins encore. Il est aussi particulièrement intéressant de confiner les plaques de maintien 12, 13 aux extrémités les plus froides des éléments du conduit 6, afin d'éviter la décomposition du nitrure de bore et la formation d'azote Des fourreaux en nitrure de bore destinés à recevoir des thermocouples 51 peuvent être collés sur les plaques de maintien 12, 13, mais ils peuvent aussi être libres au dessus des premiers 8 et deuxièmes 9 moyens de chauffage. Ces thermocouples (non représentés sur les figures 3 à 5) servent à mesurer la température du conduit 6, à la réguler et à en contrôler l'homogénéité dans la zone de dépôt. Ils sont utilisables pour des températures inférieures à 1700°C (pour des températures supérieures à 1700°C, la température devra être mesurée par pyrométrie optique ou par des thermocouples sans contacts). La soudure chaude de ces thermocouples 51 est située à l'extérieur du conduit 6 au plus près des premiers 8 et deuxièmes 9 moyens de chauffage.

Lorsque le conduit 6 est en graphite, c'est à dire lorsqu'il est conducteur, les premiers 8 et deuxièmes 9 moyens de chauffage peuvent être en graphite rigide. Ils sont alors isolés électriquement du conduit 6 par des cales, par exemple en nitrure de bore, qui les écartent du conduit 6 de quelques millimètres. Ces cales peuvent être fixées aux extrémités des premiers 8 et deuxièmes 9 moyens de chauffage et donc ne pas être trop chauffées. Une ou plusieurs gaines en graphite ou en nitrure de bore peuvent être fixées sur les faces du conduit 6 pour recevoir des thermocouples eux-mêmes isolés dans des gaines réfractaires et isolantes électriquement.

Comme on l'a représenté à la figure 4, les premiers 8 et deuxièmes 9 moyens de chauffage, ainsi que les plaques de maintien 12, 13 sont maintenues ensemble et contre le conduit 6 grâce à des berceaux 16, 17. Chaque berceau 16, 17 est constituée de deux demi-disques parallèles l'un à l'autre et reliés entre eux par des tiges qui leur sont perpendiculaires. Le diamètre des disques, constitués de deux demi-disques, correspond approximativement au diamètre interne du tube 3. Le bord rectiligne des deux demi-disques est dans un plan horizontal. Chaque bord rectiligne de chaque demi-disque comprend des encoches aptes à accueillir une plaque de maintien 12 ou 13, les premiers 8 ou les deuxièmes 9 moyens de chauffage, ainsi que la moitié de la hauteur du conduit 6. Les éléments résistifs des premiers 8 et deuxièmes 9 moyens de chauffage sont tenus isolés du conduit 6 par les berceaux 16, 17.

L'encombrement de ces berceaux 16, 17 dans la direction parallèle à l'axe longitudinal du conduit 6 correspond approximativement à la longueur des premiers 8 ou deuxièmes 9 moyens de chauffage, dans cette direction.

Ces berceaux 16, 17 sont placées approximativement au milieu du conduit 6, considéré dans sa direction longitudinale.

Avantageusement, les demi disques des berceaux 16, 17 sont au contact du conduit 6 dans les parties froides de celui-ci.

Des écrans thermiques 14, 15 sont placés de part et d'autre des premiers 8 et deuxièmes 9 moyens de chauffage, à l'extérieur de ces derniers. Plus précisément, des écrans thermiques 15 sont situés entre la paroi interne du tube 3 et la partie curviligne des demi-disques constitutifs des cages 16, 17. Ils s'étendent sous la face interne du tube 3, mais sans contact avec celui-ci, de manière concentrique, autour de la zone de chauffage. D'autres écrans thermiques 14 sont placés entre les plaques de maintien 12, 13 et les précédents 15. Ces écrans thermiques 14, 15 sont composés de deux ou trois feuilles fines en métal poli réfléchissant et réfractaire tel que le tantale, le molybdène, etc. L'écran thermique 14 ou 15 le plus externe est au plus près à quelques millimètres de la paroi interne du tube 3. Cette configuration longitudinale, avec les premiers 8 et deuxièmes 19 moyens de chauffage à l'intérieur du tube 3, au contact du conduit 6, et deux ou trois écrans thermiques 14, 15 limite beaucoup les pertes par rayonnement qui seraient autrement très importantes aux hautes températures, telles que celles exigées pour le dépôt de carbure de silicium.

Les demi-disques des berceaux 16, 17 sont constitués dans un matériau isolant électriquement et thermiquement. Ainsi les écrans thermiques 14, 15 sont isolés électriquement et thermiquement entre eux et des moyens de chauffage 8, 9.

L'ensemble constitué par le conduit 6, les premiers 8 et deuxièmes 9 moyens de chauffage, les plaques de maintien 12, 13, les berceaux 16, 17 qui maintiennent ensemble tous ces éléments, ainsi que les écrans thermiques 14, 15, est placé dans le tube 3. Cet ensemble limite la circulation de gaz à l'extérieur de la partie chaude du conduit et participe ainsi à limiter les pertes thermiques.

Avantageusement, deux disques 18, 19 sont placés entre les berceaux 16, 17 et la croix de sortie 5, perpendiculairement à l'axe du tube 3.

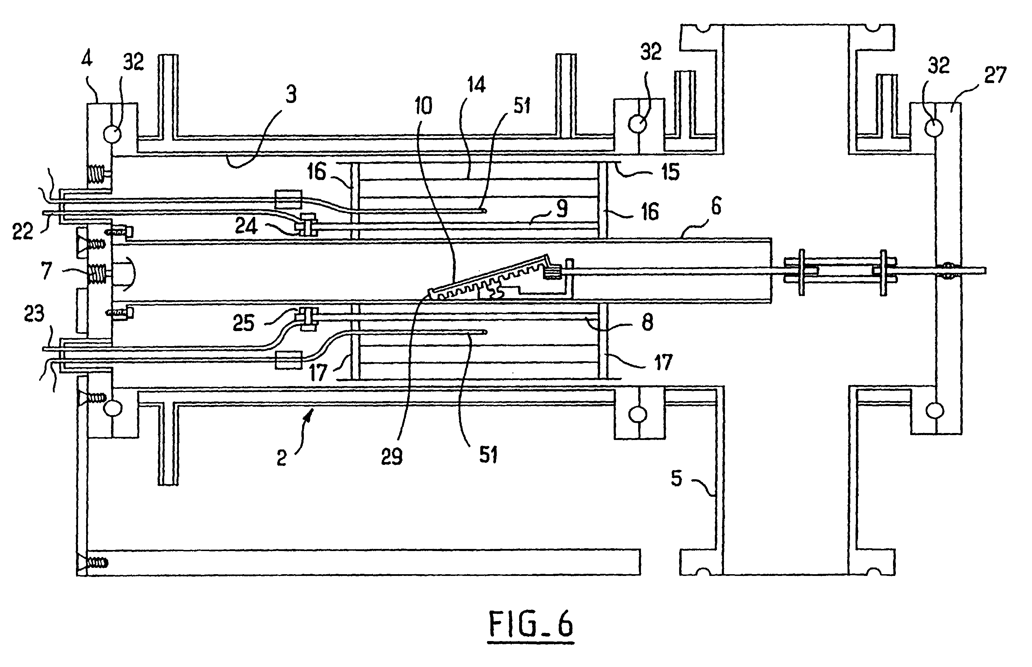

Comme représenté à la figure 5, ces disques 18, 19 sont munis d'une ouverture centrale rectangulaire dont la superficie correspond approximativement à la section transversale du conduit 6, de manière à pouvoir enfiler ces disques 18, 19 sur ce conduit 6. Ces disques 18, 19 comportent aussi des trous périphériques à l'ouverture centrale, destinés au passage de deuxièmes amenées de courant 20, 21, et de fils des thermocouples 51. L'un 19 de ces disques 18, 19 est placé dans la croix de sortie 5. L'autre 18 de ces disques 18, 19 est placé entre le disque 19 et les berceaux 16, 17. Ces disques 18, 19 ont à la fois pour rôle de maintenir le conduit 6, des deuxièmes amenées de courant 20, 21 et les fils des thermocouples 51, ainsi que celui de limiter les échanges gazeux entre l'intérieur du conduit 6 et l'espace situé entre le conduit 6 et le tube 3. Toutefois, les disques 18, 19 doivent permettre un passage des gaz, en provenance de la sortie du conduit 6, entre l'espace intérieur du conduit 6 et l'espace situé entre le conduit 6 et le tube 3, de manière à ce que la pression soit équilibrée de part et d'autre des parois 37, 38, 39, 40. En équilibrant ainsi la pression de part et d'autre des parois 37, 38, 39, 40, il est permis de réaliser ces dernières avec une faible épaisseur.

Les paires des deuxièmes amenées de courant 20, 21 sont connectées aux premières amenées de courant 22, 23 grâce aux connecteurs 24, 25. Les thermocouples 51 sont aussi connectés à l'extérieur de l'enceinte 2 par l'intermédiaire de connecteurs situés dans l'enceinte 2.

Les disques 18, 19 peuvent être constitués d'un matériau isolant électriquement et thermiquement mais pas nécessairement très réfractaire.

La porte hermétique 28 couvre une ouverture dont la largeur est approximativement égale à celle du conduit. Cette ouverture est située dans l'axe du conduit 6. Elle permet l'introduction et l'extraction des substrats 10. Un sas d'entrée est éventuellement connecté au troisième obturateur 27 pour éviter la remise à l'air du réacteur 1 pendant les opérations d'introduction et extraction des substrats 10,

Les substrats 10 sont avantageusement introduits dans le réacteur 1 grâce à un porte-substrat 29. Le porte-substrat 29 est avantageusement constitué d'un matériau bon conducteur thermique de manière à ce qu'il ait peu d'inertie thermique. Préférentiellement, ce porte-substrat 29 est réalisé en nitrure de bore mais il peut aussi être en graphite par exemple. Le porte-substrat 29 est introduit dans le réacteur 1 par un manipulateur à pinces qui coulisse sur les guides 30, 31. Ce manipulateur est constitué d'un tube fin et rigide coaxial à l'axe du conduit 6, d'une longue tige filetée à l'intérieur de ce tube, solidaire du côté du réacteur 1, de deux éléments de pinces symétriques et articulés autour d'une charnière verticale, l'extrémité extérieure de la tige filetée étant vissée dans un écrou prisonnier tournant librement. En vissant l'écrou, la tige filetée recule et la pince se resserre fermement sur une partie verticale du porte-substrat 29. Le manipulateur peut alors être mu le long des guides 30, 31 pour introduire ou extraire le porte-substrat 29. Une came sur le manipulateur peut être prévue pour permettre de surélever la pince, quand celle-ci vient de saisir le porte-substrat 29, dans sa position à l'intérieur du conduit 6, de manière à ce que celui-ci ne frotte pas la face interne de la paroi 37.

Avant la mise en service du réacteur 1, un dépôt du produit majoritaire auquel est dédié le réacteur 1 est déposé dans le conduit 6 sans substrat 10, ni porte-substrat 29, après un dégazage poussé, à une température supérieure à la température habituelle de dépôt et un balayage par le gaz vecteur. Cette étape peut être suivie par un dépôt analogue sur le porte-substrat 29 sans substrat 10. Le réacteur est alors prêt à l'emploi.

Le procédé et le réacteur selon l'invention peuvent faire l'objet de variantes.

Dans une autre variante de réalisation du réacteur (fig. 6), les amenées de courant 22, 23 et les sorties de thermocouples peuvent avantageusement être situées du même côté que l'entrée des gaz 7. Le chargement et le déchargement des substrats 10 peut alors se faire en désolidarisant le corps du réacteur 3 de la croix 5. Il est alors intéressant de mettre un porte substrat 29 tournant actionné par un passage tournant étanche et motorisé traversant axialement l'obturateur 27. Cette disposition est particulièrement utile dans les étapes (a) et (a') des procédés décrits ci-dessus.

On a décrit ci-dessus des premiers 8 et deuxièmes 9 moyens de chauffage résistifs. Ce type de moyens de chauffage permet de monter à des températures supérieures a 1750°C, avec un faible investissement en matériaux et une consommation d'energie plus faible qu'avec les procédés et les réacteurs de l'art antérieur

Par exemple, pour atteindre la fusion (1410°C) d'une tranche de silicium de 50 mm de diamètre sous un flux d'hydrogène de 8 litres par minute, à une pression de 5.10³ Pascal, une puissance de 3 kW suffit. De même, dans cet environnement. pour monter en température de 500°C à 1400°C, à une vitesse de 100°C par seconde, une ligne de puissance de 7 kW suffit également.

Cependant, il peut être envisagé d'autres types de moyens de chauffage 8, 9 même si ceux-ci apparaissent moins avantageux, tels des moyens de chauffage par induction, des moyens de chauffage dans lesquels les premiers 8 et deuxièmes 9 moyens de chauffage 9 ne forment qu'un dispositif unique disposé tout autour du conduit 6, etc.

Sur la figure 6 est représenté un autre mode de réalisation du réacteur 1 selon l'invention. Selon ce mode de réalisation, le réacteur 1 comprend une enceinte 2 constituée de deux tubes 3, 103 en acier inoxydable, concentriques, dont l'axe de révolution commun est horizontal. Dans l'espace entre les deux parois de ces tubes 3, 103 circule un fluide de refroidissement.

Un brise jet 50 est monté dans l'axe de l'entrée de gaz 7 de manière à favoriser l'obtention d'une bonne uniformité de la vitesse des gaz. Le passage de gaz 44 peut aussi éventuellement être muni d'un brise jet.

Un mécanisme 60 entraîné par un arbre 61, passant par une traversée étanche 62, et un accouplement coulissant 63, permet la rotation du substrat 10 afin d'assurer une plus grande uniformité du dépôt.

Toutes les connexions électriques et fluides sur le troisième obturateur 27 et le premier obturateur 4 sont suffisamment longues et souples pour pouvoir déplacer celles-ci d'environ deux fois la longueur du conduit 6. Avantageusement, les connexions peuvent aussi être faites uniquement sur le premier obturateur 4.

Le premier obturateur 4 est solidaire d'un chariot comprenant un support vertical 64 et un support horizontal 65.

Le support horizontal 65 peut être déplacé parallèlement à l'axe du tube 3, sur un chemin de roulement non représenté. Pour monter l'ensemble du conduit 6 et ses équipements, le premier obturateur 4 est ouvert, le tube 3 restant solidaire de la croix 5.

Pour charger ou décharger un substrat 10 on a le choix entre ouvrir le troisième obturateur 27 ou séparer le tube 3 de la croix 5.

Les substrats 10 sont introduits et maintenus dans la zone de dépôt par un porte-substrat 29 en graphite qui peut être relevé de quelques degrés, du côté aval par rapport à l'écoulement des gaz, de manière à offrir une plus grande surface de projection sur un plan vertical, dans le conduit 6. Le porte substrat est par exemple constitué d'un disque avec un rebord. Le rebord est avantageusement d'une hauteur supérieure à la hauteur du substrat 10. Le porte-substrat 29 peut entraîner en rotation le substrat 10 qu'il supporte, de manière à assurer une meilleure uniformité du dépôt. Ceci s'effectue avantageusement, grâce à une transmission mécanique, constituée d'un pignon conique d'axe horizontal et solidaire de l'arbre 61, lui même en rotation grâce à un moteur extérieur au réacteur 1, à vitesse variable assurant une vitesse de rotation du substrat pouvant aller jusqu'à 10 tours par seconde.

Selon une variante avantageuse, non représentée, du réacteur conforme à la présente invention, celui-ci comporte des premiers 8 et deuxièmes moyens de chauffage, décalés l'un par rapport à l'autre dans le sens longitudinal du conduit 6. Ceci permet également d'homogénéiser la distribution de la température sur toute la surface du substrat en favorisant la formation d'un plateau dans le profil longitudinal de température.

Selon une autre variante avantageuse, le centre du substrat 10 sur le porte substrat 29 est décalé vers l'aval du flux gazeux, dans la zone des premiers 8 et deuxièmes 9 moyens de chauffage, sans néanmoins que le substrat 10 ne sorte de cette zone.

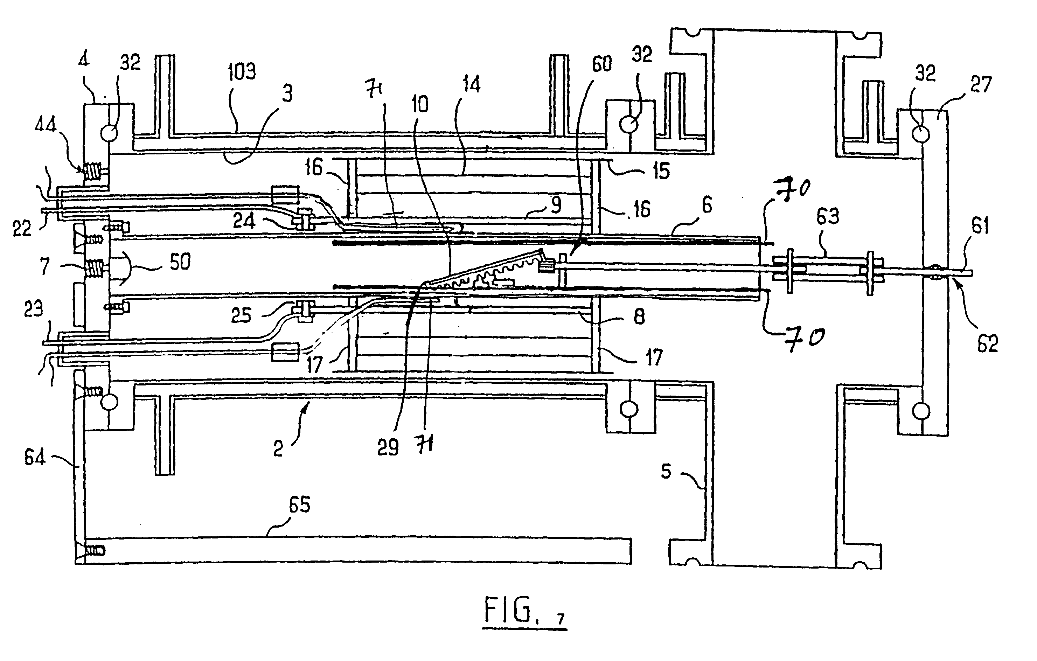

Selon encore une autre variante, illustrée par la figure 7, le conduit secondaire est constitué de plaques 70 amovibles, pouvant être introduites et retirées facilement par glissement dans des rainures non représentées du conduit 6. Ces plaques 70 sont utiles pour protéger le conduit 6 des dépôts hors du (des) substrats(s) 10. Elles sont d'un entretien aisé et sont avantageusement en graphite en nitrure de bore ou en un autre matériau réfractaire compatible avec la température du procédé et le milieu ambiant.

Selon une autre variante avantageuse aussi représentée sur la figure 7, la température peut être mesurée par des fibres 71 de pyromètres optiques situées dans des gaines solidaires du conduit 6 et entre le conduit 6 et les premiers 8 et deuxièmes 9 moyens de chauffage, plutôt que par des thermocouples 51, ceci afin d'augmenter la durée de vie des moyens de mesure de la température.

Le procédé selon l'invention permet d'obtenir les avantages précités tout en conservant un taux d'impuretés dans les couches obtenues équivalent à ceux des couches obtenues grâce aux procédés et aux réacteurs de l'art antérieur.

Un procédé et un réacteur selon l'invention sont particulièrement bien adaptés à la croissance de couches de carbure de silicium ou de nitrure d'aluminium sur des substrats 10.

## Revendications

1. Procédé de croissance cristalline d'un matériau sur un premier matériau solide (100), à partir d'un matériau en fusion, sur le premier matériau solide (100), **caractérisé par le fait qu'**il comprend :
- une étape (a) de croissance du premier matériau (100) sur un substrat (10), constitué d'un deuxième matériau (200),
- une étape (d, d') dans laquelle on fait croître des pointes cristallines du premier matériau (100) à partir de l'interface du premier matériau (100) et du matériau en fusion, en imposant un gradient de température dans la direction perpendiculaire à la surface libre du matériau en fusion tel que l'interface entre le premier materiau et le matériau en fusion soit une température plus élevée que la température à la surface libre du matériau en fusion.
- une étape (f, f') consistant à faire croître, latéralement, dans un plan principalement parallèle à celui de la surface libre du matériau en fusion, des cristaux à partir des pointes cristallines, en inversant le signe du gradient.

2. Procédé selon la revendication précédente, **caractérisé par le fait qu'**il comprend une étape (b) consistant à placer horizontalement le substrat (10), avec le premier matériau (100) en dessous du deuxième matériau (200), dans un creuset (300).

3. Procédé selon l'une des revendications 1 ou 2, **caractérisé par le fait qu'**il comprend une étape (b') consistant à placer horizontalement le substrat (10) dans un creuset (300), avec le premier matériau (100) au-dessus du deuxième matériau (200) et un troisième matériau (400) sur le premier.

4. Procédé selon la revendication 2, **caractérisé par le fait qu'**il comprend une étape (c) consistant à porter le deuxième matériau (200) en fusion en conservant le premier matériau (100) à l'état solide.

5. Procédé selon la revendication 3, **caractérisé par le fait qu'**il comprend l'étape (c') consistant à porter le troisième matériau (400) en fusion en conservant le premier matériau (100) et le deuxième matériau (200), à l'état solide.

6. Procédé selon l'une des revendications précédentes, **caractérisé par le fait qu'**il comprend une étape (d, d') dans laquelle le matériau en fusion est balayé avec un gaz précurseur dont au moins une première espèce atomique participe, avec au moins une deuxième espèce atomique provenant du matériau en fusion, à la croissance d'un quatrième matériau (500).

7. Procédé selon la revendication 6, **caractérisé par le fait que** le quatrième matériau (500) est un composé binaire.

8. Procédé selon la revendication 7, **caractérisé par le fait que** le composé binaire est du carbure de silicium.

9. Procédé selon la revendication 7, **caractérisé par le fait que** le composé binaire est du nitrure d'aluminium.

10. Procédé selon l'une des revendications 6 à 10, **caractérisé par le fait qu'**il comprend une étape (g, g') consistant à remettre une charge d'un deuxième (200) ou du troisième matériau (400) sur le quatrième matériau (500) pour en poursuivre la croissance en épaisseur.

11. Procédé selon l'une des revendications 1 à 11, **caractérisé par le fait que** l'étape (a, a') est réalisée par dépôt chimique en phase vapeur.

## Patentansprüche

1. Kristallwachstumsverfahren um ein Material auf einem ersten festen Material (100) anwachsen zu lassen, ausgehend von einem geschmolzenen Material auf dem ersten festen Material (100), **gekennzeichnet durch**:
- einen Schritt (a), um das erste Materials (100) auf einem Substrat (10) anwachsen zu lassen, das aus einem zweiten Material (200) besteht,
- ein Schritt (d, d'), bei welchem man, ausgehend von der Schnittfläche zwischen dem ersten Matrial (100) und dem geschmolzenen Material, Kristallnadeln bestehend aus dem ersten Material (100) anwachsen läßt, wobei ein Temperaturgradient in senkrechter Richtung zur freien Oberfläche des geschmolzenen Materials auferlegt wird, derart daß die Schnittstelle zwischen dem ersten Material und dem geschmolzenen Material eine Temperatur aufweist, die größer ist als die Temperatur an der freien Oberfläche des geschmolzenen Materials,
- einen Schritt (f,f'), der darin besteht, ausgehend von den Kristallnadeln Kristalle in einer zur freien Ebene des geschmolzenen Materials weitgehend parallelen Ebene lateral anwachsen zu lassen, indem das Vorzeichen des Temperaturgradienten umgekehrt wird.

2. Verfahren nach dem vorangehenden Anspruch, **dadurch gekennzeichnet, daß** es einen Schritt (b) umfaßt, der darin besteht, das Substrat horizontal in einen Schmelztiegel (300) zu plazieren derart, daß das erste Material (100) unter dem zweiten Material (200) liegt.

3. Verfahren nach einem der Ansprüche 1 oder 2, **dadurch gekennzeichnet, daß** es einen Schritt (b') umfaßt, der darin besteht, das Substrat horizontal in einen Schmelztiegel (300) zu plazieren derart, daß das erste Material (100) unter dem zweiten Material (200) liegt und auf dem ersten ein drittes Material (400) liegt.

4. Verfahren nach Anspruch 2, **dadurch gekennzeichnet, daß** es einen Schritt (c) umfaßt, der darin besteht, daß das zweite Material (200) zum Schmelzen gebracht wird, wobei das erste Matrial (100) im festen Zustand gehalten wird.

5. Verfahren nach Anspruch 3, **dadurch gekennzeichnet, daß** es einen Schritt (c') umfaßt, der darin besteht, daß das dritte Material (400) zum Schmelzen gebracht wird, wobei das erste Matrial (100) und das zweite Material (200) in festem Zustand gehalten werden.

6. Verfahren nach einem der vorangehenden Anspüchen, **dadurch gekennzeichnet, daß** es einen Schritt (d, d') umfaßt, bei welchem das geschmolzene Material mit einem Vorstufengas beströmt wird, dessen mindestens eine erste Atomsorte mit mindestens einer zweiten, aus dem geschmolzenen Material stammenden Atomsorte, am Wachstum eines vierten Materials (500) teilhaben.

7. Verfahren nach Anspruch 6, **dadurch gekennzeichnet, daß** das vierte Material (500) eine Binärverbindung ist.

8. Verfahren nach Anspruch 7, **dadurch gekennzeichnet, daß** die Binärverbindung aus Siliziumkarbid besteht.

9. Verfahren nach Anspruch 7, **dadurch gekennzeichnet, daß** die Binärverbindung aus Aluminiumnitrid besteht.

10. Verfahren nach einem der Ansprüche 6 bis 9, **dadurch gekennzeichnet, daß** es einen Schritt (g, g') umfaßt, der darin besteht, nocheinmal eine Menge eines zweiten (200) oder des dritten Materials (400) auf das vierte Material (500) aufzutragen, um das Dickenwachstum fortzusetzen.

11. Verfahren nach einem der Ansprüche 1 bis 10, **dadurch gekennzeichnet, daß** der Schritt (a, a') durch chemische Dampfabscheidung realisiert wird.

## Claims

1. Process for the crystalline growth of a material on a solid first material (100), from a molten material, on the solid first material (100), **characterized in that** it comprises:
- a step (a) of growing the first material (100) on a substrate (10), consisting of a second material (200),
- a step (d, d') in which crystalline tips of the first material (100) are grown from the interface between the first material (100) and the molten material, by imposing a temperature gradient in the direction perpendicular to the free surface of the molten material, such that the interface between the first material and the molten material is at a temperature higher than the temperature at the free surface of the molten material,
- a step (f, f') consisting in growing, laterally, in a plane mainly parallel to that of the free surface of the molten material, crystals from the crystalline tips, by reversing the sign of the gradient.

2. Process according to the preceding claim, **characterized in that** it comprises a step (b) consisting in placing the substrate (10), with the first material (100) beneath the second material (200), horizontally in a crucible (300).

3. Process according to either of Claims 1 and 2, **characterized in that** it comprises a step (b') consisting in placing the substrate (10) horizontally in a crucible (300), with the first material (100) above the second material (200) and a third material (400) on the first.

4. Process according to Claim 2, **characterized in that** it comprises a step (c) consisting in melting the second material (200) while keeping the first material (100) in the solid state.

5. Process according to Claim 3, **characterized in that** it comprises the step (c') consisting in melting the third material (400) while keeping the first material (100) and the second material (200) in the solid state.

6. Process according to one of the preceding claims, **characterized in that** it comprises a step (d, d') in which the molten material is swept with a precursor gas, at least one first atomic species of which participates, with at least one second atomic species coming from the molten material, in the growth of a fourth material (500).

7. Process according to Claim 6, **characterized in that** the fourth material (500) is a binary compound.

8. Process according to Claim 7, **characterized in that** the binary compound is silicon carbide.

9. Process according to Claim 7, **characterized in that** the binary compound is aluminium nitride.

10. Process according to one of Claims 6 to 9, **characterized in that** it comprises a step (g, g') consisting in putting another charge of a second material (200) or of the third material (400) on the fourth material (500) in order to continue its growth in thickness.

11. Process according to one of Claims 1 to 10, **characterized in that** step (a, a') is carried out by chemical vapour deposition.
